# EUROPÄISCHE PATENTSCHRIFT

(11) **EP 0 714 227 B1**
(45) Veröffentlichungstag und Bekanntmachung des Hinweises auf die Patenterteilung: **28.10.1998**
(21) Anmeldenummer: 95118326.8
(22) Anmeldetag: 22.11.1995
(51) Int. Cl.: H05K 5/00

(54) **Aus Kunststoff gespritztes Gehäuseteil mit starren, metallischen, eingespritzten Zuleitungen**
Part of a plastic casing injected with rigid metallic leads
Partie de boîtier injectée avec des conducteurs rigides métalliques d'amenée de courant

(30) Priorität: 22.11.1994 DE 9418706 U; 20.04.1995 DE 29506697 U
(43) Veröffentlichungstag der Anmeldung: 29.05.1996
(73) Patentinhaber: DODUCO GmbH, 75181 Pforzheim (DE)
(72) Erfinder: Walter,Rüdiger, D-68526 Ladenburg (DE)
(74) Vertreter: Twelmeier, Ulrich, Dipl. Phys.

(56) Entgegenhaltungen:
- DE-A- 4 017 077
- US-A- 5 278 497

## Beschreibung

Die Erfindung betrifft ein aus Kunststoff gespritztes Gehäuseteil mit starren, metallischen, eingespritzten Zuleitungen, welche eine Wand des Gehäuseteils durchqueren und ausgehend von der Wand noch auf einem Teil ihrer Länge einen Mantel aus Kunststoff haben und zum Anbringen von Meßfühlern dienen; (vgl. z.B. DE-A-4 017 077). Insbesondere handelt es sich um ein Gehäuseteil, mit welchem Meßfühler in den Luftansaugkanal eines Verbrennungsmotors eingesetzt werden können, um dort die Temperatur und/oder den Luftdurchsatz zu messen. Auf der den Meßfühlern abgewandten Seite kann das Gehäuseteil eine elektrische oder elektronische Schaltung aufnehmen und durch einen Deckel verschlossen werden. Ein solches Gehäuseteil wird aus einem thermoplastischen Kunststoff gespritzt. Dazu werden die Zuleitungen in die Spritzgießform eingelegt und vom Kunststoff umspritzt. Danach wird in das Gehäuseteil auf der einen Seite die elektrische oder elektronische Schaltung eingesetzt und mit den Zuleitungen verbunden und auf der anderen Seite werden der oder die Meßfühler mit den Enden der Zuleitungen verbunden, insbesondere verlötet. In einem automatisierten Fertigungsverfahren geschieht das Anbringen der Meßfühler so, dass die Gehäuseteile auf einem Montageförderer liegend mit senkrecht nach oben ragenden Zuleitungen den Handhabungs- und Lötwerkzeugen zugeführt werden, mit deren Hilfe die Meßfühler angebracht werden. Da diese Handhabungsgeräte und Lötwerkzeuge üblicherweise von oben her zugestellt werden, ist es nachteilig, dass die Zuleitungen senkrecht nach oben ragen und mithin senkrechte Oberflächen haben, welche den Werkzeugen nicht zugewandt sind. Dem kann man dadurch begegnen, dass man die Gehäuseteile um 90° dreht und auf eine ihrer Seitenflächen hochkant aufstellt. Dabei ist nachteilig, dass das einen zusätzlichen Arbeitsgang erfordert und das Hochkantaufstellen zu einer von Natur aus instabilen Lage führt, so dass das Gehäuseteil einer besonderen Fixierung durch einen Niederhalter, eine Klemme oder dergleichen bedarf.

Der vorliegenden Erfindung liegt die Aufgabe zugrunde, das Anbringen von Meßfühlern an die eingespritzten Zuleitungen solcher Gehäuseteile zu erleichtern.

Diese Aufgabe wird gelöst durch ein Gehäuseteil mit den im Anspruch 1 angegebenen Merkmalen. Vorteilhafte Weiterbildungen der Erfindung sind Gegenstand der abhängigen Ansprüche.

Dieser neuartige Aufbau des Gehäuseteils hat Vorteile:
- Dadurch, dass die ummantelten Zuleitungen abgebogen sind, schließt ihr abgebogenes Ende einen von 90° verschiedenen Winkel mit der Wand des Gehäuseteils ein, aus welcher die Zuleitungen nach aussen hervorragen. Dadurch kann das Gehäuseteil in seiner stabilsten Lage, nämlich flach, auf den Montageförderer gelegt werden, und dann ragen die abgebogenen Enden der Zuleitungen nicht länger senkrecht nach oben, sondern sind geneigt und wenden deshalb eine ihrer Seiten den von oben her zuzustellenden Werkzeugen zu, mit welchen die Meßfühler an den Enden der Zuleitungen angebracht werden. Dadurch ist die Zugänglichkeit der Zuleitungen verbessert.
- Die beim Anbringen der Meßfühler an den Enden der Zuleitungen auftretenden Kräfte können unmittelbar in den Montageförderer eingeleitet werden, ohne dass eine besondere Fixierung der Gehäuseteile durch einen Niederhalter oder dergleichen erforderlich wäre.
- Das Ummanteln der Zuleitungen in einem zweiten Abschnitt mit einem elastomeren Kunststoff erlaubt ein nachträgliches Biegen der Zuleitungen ohne Schaden für die isolierende Ummantelung.
- Der elastomere Kunststoff verbindet sich beim Spritzgießen des Gehäuseteils bereitwillig mit dem thermoplastischen Hartkunststoff, aus welchem das Gehäuseteil gespritzt wird.
- Das Umspritzen der Zuleitungen mit elastomerem Kunststoff erfordert keinen zusätzlichen Arbeitsgang bei der Herstellung des Gehäuseteils. Die Zuleitungen werden üblicherweise aus Bändern ausgestanzt. Dazu geht man von vorgestanzten Bändern (Leadframes) aus, in denen die Zuleitungen noch durch Stege miteinander verbunden zusammenhängen. Um die Zuleitungen lagerichtig und voneinander isoliert in die Spritzgießform einlegen zu können, müssen sie zuvor durch eine Brücke aus Kunststoff miteinander verbunden werden. Diese Kunststoffbrücke wird in einem ersten Schritt durch Spritzgießen gebildet, solange die Zuleitungen noch durch einen oder mehrere metallische Stege miteinander verbunden sind. Nach dem Spritzgießen der Brücke werden die verbliebenen metallischen Stege weggestanzt und die Zuleitungen, welche nun nur noch durch gespritze Brücken miteinander verbunden sind, in das Spritzgießwerkzeug zum Spritzen des Gehäuseteils eingelegt. Erfindungsgemäss muss man nun nur hergehen und die Brücke nicht aus dem thermoplastischen Hartkunststoff, aus welchem das Gehäuseteil gespritzt wird, sondern aus einem elastomeren Kunststoff spritzen, was lediglich eine Werkstoffänderung, aber keinen neuen Arbeitsschritt erfordert. Der verbesserte Aufbau des Gehäuseteils wird also nicht durch erhöhten Fertigungsaufwand erkauft.
- Durch den Biegevorgang werden die Zuleitungen stabiler und neigen weniger zu Schwingungen als gerade Zuleitungen. Das ist insbesondere beim Einbau in einen Strömungskanal von Bedeutung, in welchem die Luftströmung eine permanente Schwingungsanregung bewirkt.
- Wegen der verminderten Schwingungsanregung kann eine längere Lebensdauer erwartet werden.
- Die abgewinkelte Lage der Zuleitungen muss nicht durch gesonderte Mittel stabilisiert werden; die Zuleitungen selbst sind stabil genug.
- Einen zusätzlichen Beitrag zur Stabilisierung kann der Kunststoffmantel der Zuleitung bewirken, insbesondere bei einer dickeren Ummantelung.
- Eine dickere Ummantelung ist in bevorzugter Weiterbildung der Erfindung leicht möglich, wenn man an der vorgesehenen Biegestelle eine Taille im Mantel vorsieht, so dass der Mantel den Biegevorgang nicht ungebührlich behindert.
- Die Taille hat den weiteren Vorteil, dass sie die Biegestelle markiert und festlegt, so dass selbst dann, wenn die Biegung von Hand vorgenommen wird, sie zwangsläufig an der richtigen, durch die Ausbildung der Spritzgießform festgelegten Stelle erfolgt.
- Fertigungstoleranzen können durch die Taille, insbesondere wenn sie auf der einen Seite durch eine schmale Rille und auf der gegenüberliegenden Seite durch eine zur Rille parallele breitere Schwächung des Mantels gebildet ist, reduziert werden. Eine lagerichtige Biegestelle ist wichtig für ein automatisiertes Anbringen von Meßfühlern an den abgebogenen Enden der Zuleitungen.

Ein Ausführungsbeispiel der Erfindung ist in der beigefügten Zeichnung dargestellt.
- Figur 1: zeigt ein erfindungsgemässes Gehäuseteil in einer Schrägansicht,
- Figur 2: zeigt einen zu dem Gehäuseteil aus Figur 1 passenden Deckel und
- Figur 3: zeigt in einer verkleinerten Seitenansicht des Gehäuseteils die Stellung der abgebogenen Zuleitungen.

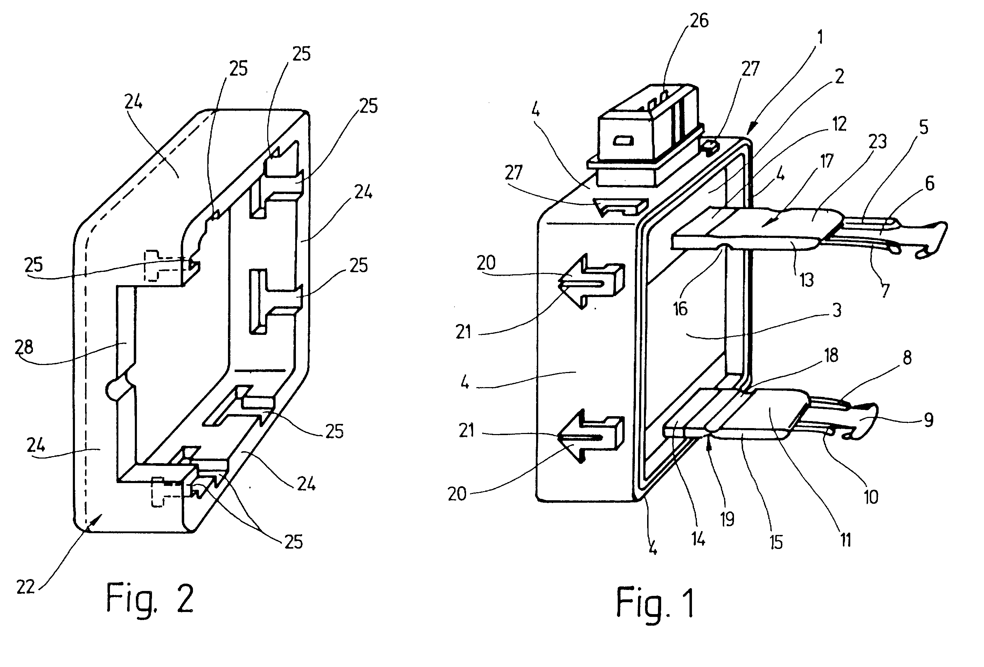

Das in Figur 1 dargestellte Gehäuseteil hat eine im wesentlichen ebene Wand 2, in welche eine Metallplatte 3, insbesondere aus Aluminium, eingespritzt ist. Die Wand 2 wird von schmalen Seitenwänden 4 umrahmt, welche in einem Stück mit der Wand 2 gespritzt werden. Durch die Wand 2 führen zwei Gruppen von je drei Zuleitungen 5, 6 und 7 sowie 8, 9 und 10 hindurch. Die Zuleitungen 5, 6 und 7 haben auf einem Teil ihrer Länge einen gemeinsamen Mantel 8. Die Zuleitungen 8, 9 und 10 haben auf einem Teil ihrer Länge einen gemeinsamen Mantel 11. Der Mantel 8 besteht aus einem ersten Abschnitt 2, welcher auf der Wand 2 fußt und in einem Arbeitsgang mit dem Gehäuseteil 1 aus einem thermoplastischen Hartkunststoff gespritzt ist. An den ersten Abschnitt 12 schließt sich ein zweiter Abschnitt 13 an, welcher aus einem elastomeren Kunststoff gespritzt ist. Der zweite Abschnitt 13 wird vor dem ersten Abschnitt 12 in einem gesonderten Spritzwerkzeug gespritzt und verbindet sich beim Spritzen des ersten Mantelabschnitts 12 mit diesem fest und innig. Dementsprechend besteht auch der Mantel 11 aus einem ersten, auf der Wand 2 fußenden Abschnitt 14 aus einem thermoplastischen Hartkunststoff und aus einem daran anschließenden zweiten Abschnitt 15 aus einem elastomeren Kunststoff.

Die Zuleitungen 5, 6 und 7 sind durch Stanzen aus einem Metallband, insbesondere aus einem mit Aluminium plattierten Kupferband, gebildet. Dementsprechend sind auch die Zuleitungen 8, 9 und 10 durch Stanzen aus einem Metallband gebildet. Deshalb bilden die drei jeweils gemeinsam ummantelten Zuleitungen 5, 6 und 7 bzw. 8, 9 und 10 ein flaches Gebilde, dessen Mantel z.B. ungefähr rechteckige Umrißlinien hat. Der flache Mantel 8 hat in seinem zweiten Abschnitt 13 auf der dem Mantel 11 zugewandten Seite eine schmale, quer über die gesamte Breite des Mantels verlaufende Rille 16 und auf der gegenüberliegenden Seite eine dazu parallele Schwächung 17, welche weniger steil abfällt als die Rille 16 und deshalb breiter als diese ist. Die Rille 16 und die Schwächung 17 bilden gemeinsam eine Taille, welche das Biegen der ummantelten Zuleitungen 5, 6 und 7 erleichtert; dabei markiert die Rille 16 die Lage der Biegestelle (Sollbiegestelle), wohingegen die Schwächung 17 auf der gegenüberliegenden Seite den Biegevorgang erleichtert. Dementsprechend hat der zweite Mantel 11 in seinem zweiten Abschnitt 15 eine dem ersten Mantel 8 zugewandte Rille 18 als Sollbiegestelle und auf der gegenüberliegenden Seite eine Schwächung 19.

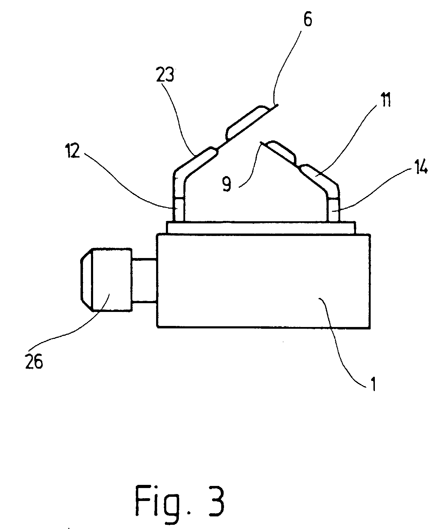

In Figur 3 sind die Zuleitungen schematisch in ihrer abgebogenen Stellung dargestellt.

An den vier Seitenflächen 4 des Gehäuseteils 1 befinden sich doppelt wirkende Rasthaken 20, bei welchen durch einen Längsschlitz 21 zwei Schenkel gebildet sind, die gegeneinander federn können. Diese Rasthaken sind in einem Stück mit dem Gehäuseteil 1 gespritzt. Sie dienen dazu, um das Gehäuseteil mit einem Deckel 22 (Figur 2) zu verrasten, der an der Innenseite seiner vier Seitenwände 24 beim Spritzgießen durch Schieber in der Spritzgießform gebildete T-förmige Ausnehmungen 25 hat, in welche die Rasthaken 20 einführbar sind und dann einrasten. Dieser Rastverschluß kann nur durch Zerstören zumindest eines Teils der Rasthaken geöffnet werden und dient als Sicherung gegen unbefugtes Öffnen des Gehäuses, in welchem sich eine elektrische Schaltung befindet. Eine der Seitenwände 24 des Deckels hat eine Ausnehmung 25, in welche ein dem Gehäuseteil 1 angespritzter Stecker 26 eingreifen kann. Sollte der Platz neben dem Stecker zu knapp sein für zwei doppelt wirkende Rasthaken, können dort auch zwei einfach wirkende Rasthaken 27 vorgesehen sein.

Nach dem Herstellen des Gehäuseteils 1 und dem Abbiegen der Zuleitungen 5 bis 7 und 8 bis 10 können an diesen Meßfühler angebracht werden, z.B. ein Temperaturfühler und ein Fühler zum Messen der Luftgeschwindigkeit oder des Luftdurchsatzes.

## Patentansprüche

1. Aus Kunststoff gespritztes Gehäuseteil (1) mit starren, metallischen, eingespritzen Zuleitungen (5-10), welche eine Wand (2) des Gehäuseteils (1) durchqueren und ausgehend von der Wand (2) noch auf einem Teil ihrer Länge einen Mantel (8, 11) aus Kunststoff haben und zum Anbringen von Meßfühlern dienen, **dadurch gekennzeichnet**, dass der Mantel (8, 11) in einem ersten, an die Wand (2) anschließenden Abschnitt (12, 14) aus dem thermoplastischen Kunststoff besteht, aus welchem das Gehäuseteil (1) gespritzt ist,
dass der Mantel (8, 11) in einem an den ersten Abschnitt (12, 14) anschließenden zweiten Abschnitt (13, 15) aus einem elastomeren Kunststoff besteht,
dass die beiden Abschnitte (12, 13; 14, 15) einstückig miteinander verbunden sind
und dass die ummantelten Zuleitungen (5-10) im zweiten Abschnitt (13, 15) abgebogen sind.

2. Gehäuseteil nach Anspruch 1, **dadurch gekennzeichnet,** dass die Zuleitungen (5-10) Stanzteile sind.

3. Gehäuseteil nach Anspruch 1 oder 2, **dadurch ge kennzeichnet,** dass der Mantel (8, 11) im zweiten Abschnitt (13, 15) eine Taille (16, 17; 18, 19) hat, in welcher die ummantelten Zuleitungen (5-10) abgebogen sind.

4. Gehäuseteil nach Anspruch 3, **dadurch gekennzeichnet,** dass die Taille durch eine schmale Rille (16, 18) auf der einen Seite der Zuleitung (5-10) und durch eine zur Rille (16, 18) parallele, aber verglichen mit der Rille (16, 18) breitere Schwächung (17, 19) des Mantels (8, 11) gebildet ist.

## Claims

1. Housing part (1) made of plastics material by injection moulding having rigid, metallic, injection-moulded supply conductors (5-10), which pass through a wall (2) of the housing part (1) and, starting from the wall (2), still have a sheath (8, 11) made of plastics material over a part of their length and serve for the attachment of measurement sensors, characterized in that the sheath (8, 11) consists, in a first portion (12, 14) adjoining the wall (2), of the thermoplastic plastics material of which the housing part (1) is made by injection moulding,
in that the sheath (8, 11) consists, in a second portion (13, 15) adjoining the first portion (12, 14), of an elastomeric plastics material,
in that the two portions (12, 13; 14, 15) are connected to one another in one piece
and in that the sheathed supply conductors (5-10) are bent off in the second portion (13, 15).

2. Housing part according to Claim 1, characterized in that the supply conductors (5-10) are punchings.

3. Housing part according to Claim 1 or 2, characterized in that the sheath (8, 11) has, in the second portion (13, 15), a constriction (16, 17; 18, 19) at which the sheathed supply conductors (5-10) are bent off.

4. Housing part according to Claim 3, characterized in that the constriction is formed by a narrow groove (16, 18) on one side of the supply conductor (5-10) and by a weakening (17, 19) of the sheath (8, 11), the weakening being parallel to the groove (16, 18) but wider than the groove (16, 18).

## Revendications

1. Elément de boîtier (1) constitué d'une matière synthétique moulée par injection, comprenant des conducteurs d'amenée métalliques rigides (5-10) moulés par injection qui traversent une paroi ce l'élément de boîtier (1) et qui, à partir de la paroi (2), possèdent encore, sur une partie de leur longueur, un revêtement (8, 11) constitué d'une matière synthétique, et qui servent à l'application de capteurs, caractérisé en ce que le revêtement (8, 11) est constitué, dans une première section (12, 14) se raccordant à la paroi (2), de la matière synthétique thermoplastique à partir de laquelle l'élément de boîtier (1) a été moulé par injection,
en ce que le revêtement (8, 11) dans une seconde section (13, 15) se raccordant à la première section (12, 14) est constitué d'une matière synthétique élastomère,
en ce que les deux sections (12, 13; 14, 15) sont reliées l'une à l'autre en une seule pièce,
et en ce que les conducteurs d'amenée (5-10) munis d'un revêtement sont cintrés dans la seconde section (13, 15).

2. Elément de boîtier selon la revendication 1, caractérisé en ce que les conducteurs d'amenée (5-10) sont des éléments estampés.

3. Elément de boîtier selon la revendication 1 ou 2, caractérisé en ce que le revêtement (8, 11) dans la seconde section (13, 15) possède un renfoncement (16, 17; 18, 19) dans lequel les conducteurs d'amenée (5-10) munis d'un revêtement sont cintrés.

4. Elément de boîtier selon la revendication 3, caractérisé en ce que le renfoncement est formé par une rainure étroite (16, 18) sur un côté du conducteur d'amenée (5-10) et par un affaissement (17, 19) du revêtement (8, 11) parallèle à la rainure (16, 18), mais dont la largeur est supérieure à celle de la rainure (16, 18).
